# EUROPEAN PATENT SPECIFICATION

(11) **EP 1 937 776 B1**
(45) Date of publication and mention of the grant of the patent: **17.03.2010**
(21) Application number: 06811545.0
(22) Date of filing: 04.10.2006
(51) Int. Cl.: C08L 75/04, C08K 5/54, C08K 7/10

(54) **HEAT-CURABLE CARBOXYLATED POLYURETHANE RESIN COMPOSITION INCLUDING SILICONE POWDER**
DURCH WÄRME HÄRTBARE HARZZUSAMMENSETZUNG AUF BASIS CARBOXYLIERTER POLYURETHANE ENTHALTEND SILIKONPULVER
COMPOSITION DE RESINE THERMODURCISSABLE DE POLYURETHANE CARBOXYLE CONTENANT DE LA POUDRE DE SILICONE

(30) Priority: 07.10.2005 JP 2005295276
(43) Date of publication of application: 02.07.2008
(73) Proprietor: Showa Denko K.K., Tokyo 105-8518 (JP)
(72) Inventor: KIMURA, Kazuya, Kawasaki-shi, Kanagawa 210-0867 (JP); UCHIDA, Hiroshi, Kawasaki-shi, Kanagawa 210-0867 (JP)
(74) Representative: Strehl Schübel-Hopf & Partner
(86) International application number: PCT/JP2006/320233
(87) International publication number: WO 2007/043536

(56) References cited:
- DATABASE WPI Week 199148 Derwent Publications Ltd., London, GB; AN 1991-350017 XP002431681 & JP 03 234758 A (SUMITOMO CHEM IND KK) 18 October 1991 (1991-10-18)
- DATABASE WPI Week 200565 Derwent Publications Ltd., London, GB; AN 2005-633116 XP002431682 & JP 2005 238497 A (MATSUSHITA ELECTRIC WORKS LTD) 8 September 2005 (2005-09-08)
- DATABASE WPI Week 200577 Derwent Publications Ltd., London, GB; AN 2005-752164 XP002431683 & JP 2005 264037 A (TOSHIBA CHEM CORP) 29 September 2005 (2005-09-29)
- DATABASE WPI Week 199336 Derwent Publications Ltd., London, GB; AN 1993-285459 XP002431684 & JP 05 202153 A (SHINETSU POLYMER CO) 10 August 1993 (1993-08-10)
- DATABASE WPI Week 200337 Derwent Publications Ltd., London, GB; AN 2003-384927 XP002431685 & JP 2003 003066 A (SHINETSU CHEM IND CO LTD) 8 January 2003 (2003-01-08)
- ANONYMOUS: "Structural Adhesives Containing Submicron Silicone Particles" 20 July 2004 (2004-07-20), IP.COM JOURNAL, IP.COM INC., WEST HENRIETTA, NY, US , XP013020900 ISSN: 1533-0001

## Description

### Technical Field

The present invention relates to a heat-curable resin composition including a heat-curable resin and silicone powder as essential components. More particularly, the invention relates to a heat-curable resin composition that is excellent in printability, non-tackiness, matte and electrical insulating properties and that is suitably used in applications including protective films and electrical insulating materials such as solder resists and interlayer insulating films, IC- and SLSI-sealing materials, and laminates. The invention also relates to a cured product of the composition, and uses of the cured product.

### Background Art

The conventional heat-curable solder resist inks contain inorganic fillers to improve printability to adapt to pith reduction, as disclosed in JP-A-H07-169100. However, impurities and reaggregates originating from the inorganic fillers deteriorate electrical properties.

Reduction of drying and curing times increases productivity but results in a cured film having a tacky surface. JP-A-2004-250464 uses inorganic fillers to prevent this tackiness. However, flaw detectors detect aggregates of the inorganic fillers as contaminants, and the yield is reduced.

DATABASE WPI Week 200337, Derwent Publications Ltd., London, GB; AN 2003-384927 &; JP 2003 003066 A (SHINETSU CHEM IND CO LTD) 8 January 2003 (2003-01-08) discloses polyamic acid/polyimide resin filled with spherically shaped silicone rubber particles.

### Disclosure of Invention

The present invention is directed to solving the above conventional problems. It is therefore an object of the invention to provide a heat-curable resin composition having excellent printability, non-tackiness, matte and electrical properties.

The present inventors diligently studied to solve the above problems. They have found that silicone powder is resistant to aggregation and does not deteriorate electrical properties, and that a heat-curable resin composition including a heat-curable resin and silicone powder as essential components is capable of solving the above problems. The invention is completed based on the findings. The present invention concerns the following.
[1] A heat-curable resin composition comprising a heat-curable resin (A) and silicone powder (B), wherein the heat-curable resin (A) comprises a carboxyl group-containing polyurethane and a heat-curable component.
[2] The heat-curable resin composition as described in [1], wherein the silicone powder (B) is spherical or substantially spherical.
[3] The heat-curable resin composition as described in [1] or [2], wherein the silicone powder (B) has a specific gravity of 0.95 to 1.5 and a particle diameter of 0.01 to 10 µm.
[4] The heat-curable resin composition as described in any one of [1] to [3], wherein the carboxyl group-containing polyurethane is obtained by reacting a polyisocyanate compound (a), a polyol compound (b) (other than compound (c)), and a carboxyl group-containing dihydroxy compound (c).
[5] The heat-curable resin composition as described in [4], wherein the carboxyl group-containing polyurethane is obtained by reacting the compounds (a), (b) and (c), and a monohydroxy compound (d) and/or a monoisocyanate compound (e).
[6] A solder resist ink comprising the heat-curable resin composition as described in any one of [1] to [5].
[7] A cured product produced by curing the heat-curable resin composition as described in any one of [1] to [5].
[8] An insulating protective film comprising the cured product as described in [7].
[9] A printed circuit board partially or completely covered with the cured product as described in [7].
[10] A flexible printed circuit board partially or completely covered with the cured product as described in [7].
[11] A chip on film (COF) partially or completely covered with the cured product as described in [7].
[12] An electronic part including the cured product as described in [7].

There have been concerns that the conventional solder resist films are tacky, reaggregated inorganic fillers reduce the productivity, and inorganic fillers decrease electrical properties. The heat-curable resin composition according to the present invention achieves a good balance among printability, non-tackiness, matte and electrical properties, and forms superior solder resists and protective films at low cost with good productivity.

### Best Mode for Carrying Out the Invention

The heat-curable resin composition according to the present invention will be described in detail hereinbelow.

The heat-curable resin composition includes a heat-curable resin (A) and silicone powder (B), and may contain a curing agent or a curing accelerator (C) as required. These components of the heat-curable resin composition will be described below.

### (A) Heat-curable resin

From the viewpoints of flexibility and electrical insulating properties, combinations of carboxyl group-containing polyurethanes and heat-curable components are contained in the heat-curable resin (A) used in the present invention.

### <Carboxyl group-containing polyurethanes>

The carboxyl group-containing polyurethanes suitably used in the invention have two or more carboxyl groups in the molecule and have a urethane linkage formed by reaction of a polyisocyanate compound and a polyol compound. Such carboxyl group-containing polyurethanes may be synthesized by reacting a polyisocyanate compound (a), a polyol compound (b) and a carboxyl group-containing dihydroxy compound (c). The reaction may further involve a monohydroxy compound (d) and/or a monoisocyanate compound (e) as end-capping agents.

Examples of the polyisocyanate compounds (a) include diisocyanates such as 2, 4-tolylene diisocyanate, 2, 6-tolylene diisocyanate, isophorone diisocyanate, 1,6-hexamethylene diisocyanate, 1,3-trimethylene diisocyanate, 1,4-tetramethylene diisocyanate, 2,2,4-trimethylhexamethylene diisocyanate, 2,4,4-trimethylhexamethylene diisocyanate, 1,9-nonamethylene diisocyanate, 1,10-decamethylene diisocyanate, 1,4-cyclohexane diisocyanate, 2,2'-diethyl ether diisocyanate, diphenylmethane-4,4'-diisocyanate, (o, m or p)-xylene diisocyanate, methylenebis(cyclohexyl isocyanate), cyclohexane-1,3-dimethylene diisocyanate, cyclohexane-1,4-dimethylene diisocyanate, 1,5-naphthalene diisocyanate, p-phenylene diisocyanate, 3,3'-methyleneditolylene-4,4'-diisocyanate, 4,4'-diphenylether diisocyanate, tetrachlorophenylene diisocyanate, norbornane diisocyanate and hydrogenated (1,3-or 1,4-) xylylene diisocyanate. These may be used singly or in combination of two or more kinds.

Examples of the polyol compounds (b) (other than compounds (c)) include low-molecular weight diols, polycarbonate diols, polyether diols, polybutadienes with terminal hydroxyl groups, and polyester diols. These may be used singly or in combination of two or more kinds. From the viewpoints of flexibility, electrical properties and heat resistance, polycarbonate diols are preferable.

Examples of the carboxyl group-containing dihydroxy compounds (c) include 2,2-dimethylolpropionic acid, 2,2-dimethylolbutanoic acid, N,N-bishydroxyethylglycine and N,N-bishydroxyethylalanine. These may be used singly or in combination of two or more kinds. From the viewpoint of solubility in solvents, 2,2-dimethylolpropionic acid and 2,2-dimethylolbutanoic acid are preferable.

Examples of the monohydroxy compounds (d) include 2-hydroxyethyl (meth)acrylate, hydroxypropyl (meth)acrylate, hydroxybutyl (meth)acrylate, cyclohexanedimethanol mono(meth)acrylate, caprolactone adducts and alkylene oxide adducts of these (meth) acrylates, glycerin di (meth) acrylate, trimethylol di(meth)acrylate, pentaerythritol tri(meth)acrylate, dipentaerythritol penta(meth)acrylate, ditrimethylolpropane tri(meth)acrylate, allyl alcohol, allyloxyethanol, glycolic acid, hydroxypivalic acid, methanol, ethanol, n-propanol, isopropanol, n-butanol, isobutanol, sec-butanol, t-butanol, amyl alcohol, hexyl alcohol and octyl alcohol. These may be used singly or in combination of two or more kinds.

Examples of the monoisocyanate compounds (e) include (meth)acryloyloxyethyl isocyanate, phenyl isocyanate, hexyl isocyanate and dodecyl isocyanate. These may be used singly or in combination of two or more kinds.

The carboxyl group-containing polyurethanes preferably range in number-average molecular weight from 500 to 100, 000, more preferably from 8,000 to 30,000. The number-average molecular weight is in terms of polystyrene as measured by gel permeation chromatography (GPC). When the carboxyl group-containing polyurethanes have a number-average molecular weight less than that described above, the elongation, flexibility and strength of cured films are often deteriorated. Any number-average molecular weight exceeding the above range can result in cured films that are solid and less flexible.

The carboxyl group-containing polyurethanes preferably range in acid value from 5 to 150 mgKOH/g, more preferably 30 to 120 mgKOH/g. When the acid value is less than that described above, the polyurethane shows low reactivity with the curable component, often resulting in deteriorated heat resistance. Any acid value exceeding the above range can result in cured films that have deteriorated properties as resists, for example alkali resistance and electrical properties. The acid value of the resins is determined in accordance with JIS K 5407.

### <Heat-curable components>

Examples of the heat-curable components include epoxy resins capable of reacting with the carboxyl group-containing polyurethanes. Such epoxy resins include epoxy compounds having two or more epoxy groups in the molecule, such as bisphenol A epoxy resins, hydrogenated bisphenol A epoxy resins, brominated bisphenol A epoxy resins, bisphenol F epoxy resins, novolac epoxy resins, phenol novolac epoxy resins, cresol novolac epoxy resins, N-glycidyl epoxy resins, novolac epoxy resins of bisphenol A, chelate epoxy resins, glyoxal epoxy resins, amino group-containing epoxy resins, rubber-modified epoxy resins, dicyclopentadiene phenolic epoxy resins, silicone-modified epoxy resins and ε-caprolactone-modified epoxy resins. Halogen atoms such as chlorine and bromine, and atoms such as phosphorous may be introduced in the structures of these compounds to achieve flame retardance. The heat-curable components further include bisphenol S epoxy resins, diglycidyl phthalate resins, heterocyclic epoxy resins, bixylenol epoxy resins, biphenol epoxy resins and tetraglycidyl xylenoyl ethane resins.

The heat-curable resin composition may contain one or more heat-curable components. The amount of the heat-curable component is desirably such that the ratio of the epoxy equivalent of the curable component to the carboxyl equivalent of the carboxyl group-containing polyurethane is 1.0 to 3.0. When the epoxy to carboxyl equivalent ratio is less than that described above, the heat-curable resin composition often gives cured films with insufficient electrical insulating properties. Any ratio more than that described above tends to result in greater shrinkage of cured films and the cured films used as insulting protective films for flexible printed circuit boards (FPC) show bad warpage.

### (B) Silicone powders

The silicone powders (B) include powders of silicone oils on inorganic carriers, powders of silicone resins (three dimensionally crosslinked silicone oils) and powders of silicone rubbers. The silicone powders are resistant to aggregation and do not deteriorate electrical properties. Therefore, the heat-curable resin composition containing the silicone powder shows superior printability, non-tackiness, matte and electrical insulating properties.

Examples of the silicone powders (B) include TOREFIL F201, TOREFIL F202, TOREFIL F204, TOREFIL R-900, TOREFIL R-902A, TOREFIL E-500, TOREFIL E-600, TOREFIL E-601 and TOREFIL E-850 manufactured by Dow Corning Toray Silicone Co., Ltd., and KMP-597, KMP-590, KMP-701, X-52-854, X-52-1621, KMP-605 and X-52-7030 manufactured by Shin-Etsu Chemical Co., Ltd.

To prevent aggregation, the silicone powder (B) is preferably spherical or substantially spherical. The silicone powder (B) preferably has a particle diameter of 0.01 to 10 µm, more preferably 0.1 to 8 µm. When the particle diameter is less than that described above, the powder often does not contribute to printability, matte and non-tackiness. Particle diameters exceeding the above range can deteriorate electrical properties. The silicone powder (B) preferably has a specific gravity of 0. 90 to 1.5, more preferably 0.95 to 1.4. When the specific gravity is less than that described above, the powder tends to float in an upper part of the composition as ink and will not be dispersed uniformly. The powder having a specific gravity exceeding the above range is unevenly distributed and is concentrated near the base under the paint film, often leading to reduced matte and non-tackiness.

The silicone powders (B) may be used singly or in combination of two or more kinds. The amount of the silicone powders (B) is not particularly limited, and is preferably in the range of 1 to 15% by mass, more preferably 5 to 12% by mass relative to 100% by mass of the heat-curable resin. Too little silicone powder (B) tends to be incapable of improving printability, matte and non-tackiness. Too much silicone powder (B) is hardly dispersed uniformly and tends to reduce application properties.

### (C) Curing agents

The heat-curable resin composition may contain a curing agent (C) as required to accelerate curing reaction. The use of the curing agent improves properties such as adhesion, chemical resistance and heat resistance.

Examples of the curing agents (C) include known curing agents and curing accelerators, for example:
imidazole derivatives such as 2MZ, 2E4MZ, C11Z, C17Z, 2PZ, 1B2MZ, 2MZ-CN, 2E4MZ-CN, C11Z-CN, 2PZ-CN, 2PHZ-CN, 2MZ-CNS, 2E4MZ-CNS, 2PZ-CNS, 2MZ-AZINE, 2E4MZ-AZINE, C11Z-AZINE, 2MA-OK, 2P4MHZ, 2PHZ and 2P4BHZ manufactured by SHIKOKU CHEMICALS CORPORATION;
guanamines such as acetoguanamine and benzoguanamine;
polyamines such as diaminodiphenylmethane, m-phenylenediamine, m-xylenediamine, diaminodiphenylsulfone, dicyandiamide, urea, urea derivatives, melamine and polybasic hydrazide;
organic acid salts and/or epoxy adducts of the above compounds;
amine complexes of boron trifluoride;
triazine derivatives such as ethyldiamino-S-triazine, 2,4-diamino-S-triazine and 2,4-diamino-6-xylyl-S-triazine;
amines such as trimethylamine, triethanolamine, N,N-dimethyloctylamine, N-benzyldimethylamine, pyridine, N-methylmorpholine, hexa(n-methyl)melamine, 2,4,6-tris(dimethylaminophenol), tetramethylguanidine and m-aminophenol;
polyphenols such as polyvinylphenol, polyvinylphenol bromide, phenol novolac and alkylphenol novolacs;
organic phosphines such as tributylphosphine, triphenylphosphine and tris-2-cyanoethylphosphine;
phosphonium salts such as tri-n-butyl(2,5-dihydroxyphenyl)phosphonium bromide and hexadecyltributylphosphonium chloride;
quaternary ammonium salts such as benzyltrimethylammonium chlorine and phenyltributylammonium chloride;
anhydrides of the polybasic acids mentioned above;
photo-cationic polymerization catalysts such as diphenyl iodonium tetrafluoroborate, triphenyl sulfonium hexafluoroantimonate, 2,4,6-triphenyl thiopyrilium hexafluorophosphate, IRGACURE 261 manufactured by Ciba Specialty Chemicals Inc., and Optomer SP-170 manufactured by Asahi Denka Co., Ltd.;
styrene-maleic anhydride resin; and
equimolar reaction products of phenyl isocyanate and dimethylamine, and equimolar reaction products of dimethylamine and organic polyisocyanates such as tolylene diisocyanate and isophorone diisocyanate.

The curing agents may be used singly or in combination of two or more kinds. The curing agents are not compulsory in the present invention. When fast curing is desired, the curing agents may be used in amounts of not more than 25% by mass relative to 100% by mass of the heat-curable component. When the amount exceeds 25% by mass, the cured product contains much sublimative components.

### (D) Organic solvents

The heat-curable resin composition of the present invention may be produced by dissolving or dispersing the heat-curable resin (A), the silicone powder (B) and optionally the curing agent (C) with a mixer such as a disperser, a kneader, a three-roll mill or a bead mill. An organic solvent (D) inactive with the functional groups in the composition may be used to facilitate the dissolution or dispersion of the heat-curable resin (A) and silicone powder (B) or to obtain a viscosity appropriate for application.

Examples of the organic solvents (D) include toluene, xylene, ethylbenzene, nitrobenzene, cyclohexane, isophorone, diethylene glycol dimethyl ether, ethylene glycol diethyl ether, carbitol acetate, propylene glycol methyl ether acetate, propylene glycol ethyl ether acetate, dipropylene glycol methyl ether acetate, diethylene glycol ethyl ether acetate, methyl methoxypropionate, ethyl methoxypropionate, methyl ethoxypropionate, ethyl ethoxypropionate, ethyl acetate, n-butyl acetate, isoamyl acetate, ethyl lactate, acetone, methyl ethyl ketone, cyclohexanone, N,N-dimethylformamide, N,N-dimethylacetamide, N-methylpyrrolidone, γ-butyrolactone, dimethylsulfoxide, chloroform and ethylene chloride. These solvents may be used singly or in combination of two or more kinds.

### (E) Additives

The heat-curable resin composition may contain known additives including inorganic fillers such as barium sulfate, talcs, calcium carbonate, aluminas, glass powders, quartz powders and silicas; fibrous reinforcing materials such as glass fibers, carbon fibers and boron nitride fibers; colorants such as titanium oxide, zinc oxide, carbon blacks, iron blacks, organic pigments and organic dyes; antioxidants such as hindered phenolic compounds, phosphorous compounds and hindered.amine compounds; and UV absorbers such as benzotriazole compounds and benzophenone compounds. Viscosity modifiers, flame retardants, antibacterial agents, fungicides, anti-aging agents, anti-static agents, plasticizers, lubricants and foaming agents may be used as required.

### Examples

The present invention will be described in greater detail by examples below.

### <Synthetic Example>

A reaction vessel equipped with a stirrer, a thermometer and a condenser was charged with 70.7 g of polycarbonate diol [C-1065N manufactured by KURARAY CO., LTD., molar ratio of raw material diols (1,9-nonanediol:2-methyl-1,8-octanediol) = 65:35, molecular weight: 991] as polyol compound, 13.5 g of 2,2-dimethylolbutanoic acid (manufactured by Nippon Kasei Chemical Co., Ltd.) as carboxyl group-containing dihydroxy compound and 128.9 g of diethylene glycol ethyl ether acetate (manufactured by DAICEL CHEMICAL INDUSTRIES, LTD.) as solvent. The materials were dissolved at 90°C. The reaction liquid was cooled to 70°C, and 42.4 g of mthylenebis(4-cyclohexyl isocyanate) [DESMODUR W manufactured by Sumika Bayer Urethane Co., Ltd.] as polyisocyanate was added dropwise with a dropping funnel over a period of 30 minutes. Rafter the completion of the dropwise addition, reaction was performed at 80°C for 1 hour, 09°C for 1 hour, and 100 °C for 2 hours. When the substantial disappearance of the isocyanate was confirmed, 1.46 g of isobutanol (manufactured by Wako Pure Chemical Industries, Ltd.) was added dropwise and reaction was performed at 105°C for 1.5 hours. The carboxyl group-containing polyurethane obtained had a number-average molecular weight of 6,800 and an acid value of the solid of 39.9 mgKOH/g.

### [Example 1]

The polyurethane solution (solid concentration: 50% by mass) obtained in Synthetic Example 1 was combined witch, based on 100% by mass'of the solid polyurethane:
37.5% by mass of an epoxy resin (EPIKOTE 828EL manufactured by JAPAN EPOXY RESIN CO., LTD.), an amount such that the equivalent ratio of the epoxy groups to the carboxyl groups in the polyurethane was 1.1;
4% by mass of melamine as curing agent; and
10% by mass of silicone resin powder KMP-701
(manufactured by Shin-Etsu Chemical Co., Ltd., specific gravity: 1.3, particle diameter: 3.5 µm) as silicone powder.

The resultant composition was kneaded by being passed through a three-roll mill (RIII-1 RM-2 manufactured by Kodaira Seisakusho Co., Ltd.) three times. Consequently, a solder resist ink was prepared.

### [Example 2]

A solder resist ink was prepared in the same manner as in Example 1, except that silicone resin powder KMP-701 was replace by silicone rubber powder KMP-597 (manufactured by Shin-Etsu Chemical Co., Ltd., specific gravity: 0.99, particle diameter: 2 µm) as silicone powder.

### [Example 3]

A solder resist ink was prepared in the same manner as in Example 1, except that silicone resin powder KMP-701 was replaced by silicone resin powder X-52-854 (manufactured by Shin-Etsu Chemical Co., Ltd., specific gravity: 1.3, particle diameter: 0.8 µm) as silicone powder.

### [Comparative Example 1]

A solder resist ink was prepared in the same manner as in Example 1, except that the silicone powder was not used.

### [Comparative Example 2]

A solder resist ink was prepared in the same manner as in Example 1, except that the silicone powder was replaced by silicone oil KF-56 (manufactured by Shin-Etsu Chemical Co., Ltd.).

### [Comparative Example 3]

A solder resist ink was prepared in the same manner as in Example 1, except that the silicone powder was replaced by talc Hi-Filler 5000 PJ (manufactured by Matsumura Sangyo K.K.).

### [Comparative Example 4]

A solder resist ink was prepared in the same manner as in Example 1, except that the silicone powder was replaced by synthetic mica Somasif MEE (manufactured by Co-op Chemical Co. , Ltd.).

### [Comparative Example 5]

A solder resist ink was prepared in the same manner as in Example 1, except that the silicone powder was replaced by organically modified smectite Bentone 38 (manufactured by ELEMENTIS JAPAN K.K.).

### [Comparative Example 6]

A solder resist ink was prepared in the same manner as in Example 1, except that the silicone powder was replaced by organic bentonite New D Orben (manufactured by SHIRAISHI KOGYO).

### [Comparative Example 7]

A solder resist ink was prepared in the same manner as in Example 1, except that the silicone powder was replaced by spherical silica Quartron SP-1B (manufactured by FUSO CHEMICAL CO., LTD.).

### [Evaluation]

The solder resist inks obtained in Examples 1-3 and Comparative Examples 1-7 were evaluated for printability, matte, non-tackiness and electrical properties as described below. The results are shown in Table 1.

### <Printability>

The solder resist ink was applied to an IPC-C (comb-shaped pattern) of a commercially available substrate (IPC standard) by screen printing through a No. 100-mesh polyester plate. The ink was dried at 80°C for 30 minutes, and cured at 150°C for 1 hour. The cured ink on the fine wires was observed with a microscope, and the bleeding was examined.
The evaluation was based on the following criteria.
AA: The bleeding was less than 50 µm.
BB: The bleeding was from 50 to 100 µm.
CC: The bleeding was more than 100 µm.

### <Matte>

The solder resist ink was applied to a substrate by screen printing through a No. 100-mesh polyester plate. The ink was dried at 80°C for 30 minutes, and cured at 150°C for 1 hour. The substrate used herein was a polyimide film 25 µm in thickness (Kapton® 100EN, manufactured by DU PONT-TORAY CO., LTD.). The cured film was visually observed and evaluated based on the following criteria.
AA: The film was matte.
BB: The film was slightly matte.
CC: The film had gloss.

### <Non-tackiness>

The solder resist ink was applied to a substrate by screen printing through a No. 100-mesh polyester plate. The ink was dried at 80°C for 30 minutes, and cured at 150°C for 1 hour. The substrate used herein was a polyimide film 25 µm in thickness (Kapton® 100EN, manufactured by DU PONT-TORAY CO., LTD.). The coated substrates were laminated through resist-coated surfaces, and the tackiness was evaluated based on the following criteria.
AA: The resist-coated surfaces had no tackiness.
BB: The resist-coated surfaces had slight tackiness.
CC: The resist-coated surfaces had tackiness and were bonded together.

### <Long-term reliability>

The solder resist ink was applied to an IPC-C (comb-shaped pattern) of a commercially available substrate (IPC standard) by screen printing through a No. 100-mesh polyester plate. The ink was dried at 80°C for 30 minutes, and cured at 150°C for 1 hour. The coated substrate was exposed to 85°C and 85% RH, and a bias voltage of 100 V was applied to the substrate for 2,000 hours. Electrical insulating properties were evaluated based on the following criteria.
AA: No migration and no decrease in insulation resistance resulted.
BB: Migration or decreased insulation resistance resulted after 1,000-2,000 hours.
CC: Migration or decreased insulation resistance resulted within 1,000 hours.

**Table 1**

| | Component | Printability | Matte | Non-tackiness | Electrical properties |
|---|---|---|---|---|---|
| Ex. 1 | Silicone powder | AA | AA | BB | AA |
| Ex. 2 | Silicone powder | AA | AA | AA | AA |
| Ex. 3 | Silicone powder | AA | BB | BB | AA |
| Comp. Ex. 1 | - | CC | CC | CC | AA |
| Comp. Ex. 2 | Silicone oil | CC | CC | CC | AA |
| Comp. Ex. 3 | Inorganic filler | AA | CC | BB | CC |
| Comp. Ex. 4 | Inorganic filler | BB | AA | AA | CC |
| Comp. Ex. 5 | Inorganic filler | AA | BB | BB | BB |
| Complex. 6 | Inorganic filler | BB | BB | AA | CC |
| Comp. Ex. 7 | Inorganic filler | CC | AA | AA | BB |

### Industrial Applicability

The heat-curable resin composition is capable of giving cured products excellent in printing properties, non-tackiness, matte and electrical insulating properties and is suitably used in applications including electrical insulating materials such as solder resists and interlayer insulating films, IC- and SLSI-sealing materials, laminates and electronic parts.

The cured product of the composition is used as insulating protective films partially or completely covering printed circuit boards, flexible printed circuit boards and chip on films (COF).

## Claims

1. A heat-curable resin composition comprising a heat-curable resin (A) and silicone powder (B), wherein the heat-curable resin (A) comprises a carboxyl group-containing polyurethane and a heat-curable component.

2. The heat-curable resin composition according to claim 1, wherein the silicone powder (B) is spherical or substantially spherical.

3. The heat-curable resin composition according to claim 1 or 2, wherein the silicone powder (B) has a specific gravity of 0.95 to 1.5 and a particle diameter of 0.01 to 10 µm.

4. The heat-curable resin composition according to any one of claims 1 to 3, wherein the carboxyl group-containing polyurethane is obtained by reacting a polyisocyanate compound (a), a polyol compound (b) (other than compound (c)), and a carboxyl group-containing dihydroxy compound (c).

5. The heat-curable resin composition according to claim 4, wherein the carboxyl group-containing polyurethane is obtained by reacting the compounds (a), (b) and (c), and a monohydroxy compound (d) and/or a monoisocyanate compound (e).

6. A solder resist ink comprising the heat-curable resin composition claimed in any one of claims 1 to 5.

7. A cured product produced by curing the heat-curable resin composition claimed in any one of claims 1 to 5.

8. An insulating protective film comprising the cured product claimed in claim 7.

9. A printed circuit board partially or completely covered with the cured product claimed in claim 7.

10. A flexible printed circuit board partially or completely covered with the cured product claimed in claim 7.

11. A chip on film partially or completely covered with the cured product claimed in claim 7.

12. An electronic part including the cured product claimed in claim 7.

## Patentansprüche

1. Wärmehärtbare Harzzusammensetzung, die ein wärmehärtbares Harz (A) und Silikonpulver (B) enthält, wobei das wärmehärtbare Harz (A) ein Carboxygruppen enthaltendes Polyurethan und eine wärmehärtbare Komponente enthält.

2. Wärmehärtbare Harzzusammensetzung nach Anspruch 1, worin das Silikonpulver (B) kugelförmig oder im wesentlichen kugelförmig ist.

3. Wärmehärtbare Harzzusammensetzung nach Anspruch 1 oder 2, worin das Silikonpulver (B) ein spezifisches Gewicht von 0,95 bis 1,5 und einen Teilchendurchmesser von 0,01 bis 10 µm hat.

4. Wärmehärtbare Harzzusammensetzung nach einem der Ansprüche 1 bis 3, wobei das Carboxygruppen enthaltende Polyurethan erhalten wird, indem eine Polyisocyanatverbindung (a), eine Polyolverbindung (b) (eine andere als die Verbindung (c)) und eine Carboxygruppen enthaltende Dihydroxyverbindung (c) umgesetzt werden.

5. Wärmehärtbare Harzzusammensetzung nach Anspruch 4, worin das Carboxygruppen enthaltende Polyurethan erhalten wird, indem die Verbindungen (a), (b) und (c) und eine Monohydroxyverbindung (d) und/oder eine Monoisocyanatverbindung (e) umgesetzt werden.

6. Lötstopptinte, die die wärmehärtbare Harzzusammensetzung nach einem der Ansprüche 1 bis 5 enthält.

7. Gehärtetes Produkt, hergestellt durch Härten der wärmehärtbaren Harzzusammensetzung nach einem der Ansprüche 1 bis 5.

8. Isolierschutzfolie, welche das gehärtete Produkt nach Anspruch 7 enthält.

9. Leiterplatte, die teilweise oder vollständig mit dem gehärteten Produkt nach Anspruch 7 bedeckt ist.

10. Flexible Leiterplatte, die teilweise oder vollständig mit dem gehärteten Produkt nach Anspruch 7 bedeckt ist.

11. Chip auf einer Folie, teilweise oder vollständig bedeckt mit dem gehärteten Produkt nach Anspruch 7.

12. Elektronisches Teil, welches das gehärtete Produkt nach Anspruch 7 umfasst.

## Revendications

1. Composition de résine durcissable à la chaleur comprenant une résine durcissable à la chaleur (A) et une poudre de silicone (B), où la résine durcissable à la chaleur (A) comprend un polyuréthane contenant des groupes carboxyle et un composant durcissable à la chaleur.

2. Composition de résine durcissable à la chaleur selon la revendication 1 où la poudre de silicone (B) est sphérique ou sensiblement sphérique.

3. Composition de résine durcissable à la chaleur selon la revendication 1 ou 2 où la poudre de silicone (B) a une densité de 0,95 à 1,5 et un diamètre de particule de 0,01 à 10 µm.

4. Composition de résine durcissable à la chaleur selon l'une quelconque des revendications 1 à 3 où le polyuréthane contenant des groupes carboxyle est obtenu par réaction d'un composé polyisocyanate (a), d'un composé polyol (b) (différent du composé (c)) et d'un composé dihydroxylé contenant un groupe carboxyle (c).

5. Composition de résine durcissable à la chaleur selon la revendication 4 où le polyuréthane contenant des groupes carboxyle est obtenu par réaction des composés (a), (b) et (c) et d'un composé monohydroxylé (d) et/ou d'un composé monoisocyanate (e).

6. Encre pour résist pour brasage comprenant la composition de résine durcissable à la chaleur selon l'une quelconque des revendications 1 à 5.

7. Produit durci produit par durcissement de la composition de résine durcissable à la chaleur selon l'une quelconque des revendications 1 à 5.

8. Film protecteur isolant comprenant le produit durci selon la revendication 7.

9. Plaquette de circuit imprimé partiellement ou complètement recouverte du produit durci selon la revendication 7.

10. Plaquette de circuit imprimé flexible partiellement ou complètement recouverte du produit durci selon la revendication 7.

11. Puce sur bande partiellement ou complètement recouverte du produit durci selon la revendication 7.

12. Pièce électronique incluant le produit durci selon la revendication 7.
